# EUROPEAN PATENT APPLICATION

(11) **EP 4 440 283 A1**
(43) Date of publication of application: **02.10.2024**
(21) Application number: 24165073.8
(22) Date of filing: 21.03.2024
(51) Int. Cl.: H10K 59/131

(54) **DISPLAY APPARATUS**

(30) Priority: 24.03.2023 KR 20230039099; 17.04.2023 KR 20230050246
(71) Applicant: Samsung Display Co., Ltd., Yongin-si, Gyeonggi-do 17113 (KR)
(72) Inventor: Lee, Jongchan, 17113 Yongin-si, Gyeonggi-do (KR); Lee, Jinsuk, 17113 Yongin-si, Gyeonggi-do (KR); Oh, Yuri, 17113 Yongin-si, Gyeonggi-do (KR); Yoo, Kibok, 17113 Yongin-si, Gyeonggi-do (KR); Lee, Donghyeok, 17113 Yongin-si, Gyeonggi-do (KR)
(74) Representative: Gulde & Partner

(57) **Abstract**

A display apparatus (1) includes: a plurality of transistors (T1, T2) in a display area (DA); a plurality of light-emitting diodes (OLED) in the display area (DA), and electrically connected to the plurality of transistors (T1, T2); a power voltage supply line (10, 20) in a peripheral area (PA) outside the display area (DA); a partition wall (210) in the peripheral area (PA), and overlapping with a part (1100E) of the power voltage supply line (10, 20); and an encapsulation layer (320) on the plurality of light-emitting diodes (OLED). The power voltage supply line (10, 20) has a multilayered structure including: a first conductive layer (10A, 20A); a second conductive layer (10B, 20B) on the first conductive layer (10A, 20A); and a third conductive layer (10C, 20C) on the second conductive layer (10B, 20B). A side shape of a first portion (10-1, 20-1) of the power voltage supply line (10, 20) that does not overlap with the partition wall (210) is different from a side shape of a second portion (10-2, 20-2) of the power voltage supply line (10I 20) overlapping with the partition wall (210).

## Description

### BACKGROUND

### 1. Field

Aspects of one or more embodiments of the present disclosure relate to a display apparatus.

### 2. Description of the Related Art

With the development of display apparatuses that visually display electrical signals, display apparatuses are being used for various purposes. As display apparatuses are used in various ways, the designs of display apparatuses capable of providing a high-quality image, while reducing the area of a peripheral area, are being developed.

### SUMMARY

One or more embodiments of the present disclosure are directed to a structure of a display apparatus, for example, such as a structure of a peripheral area of the display apparatus.

However, the present disclosure is not limited thereto, and additional aspects and features will be set forth, in part, in the description that follows, and in part, will be apparent from the description, or may be learned by practicing one or more of the presented embodiments of the present disclosure.

According to one or more embodiments of the present disclosure, a display apparatus includes: a plurality of transistors in a display area; a plurality of light-emitting diodes in the display area, and electrically connected to the plurality of transistors; a power voltage supply line in a peripheral area outside the display area; a partition wall in the peripheral area, and overlapping with a part of the power voltage supply line; and an encapsulation layer on the plurality of light-emitting diodes. The power voltage supply line has a multi-layered structure including: a first conductive layer; a second conductive layer on the first conductive layer; and a third conductive layer on the second conductive layer. A side shape of a first portion of the power voltage supply line that does not overlap with the partition wall is different from a side shape of a second portion of the power voltage supply line overlapping with the partition wall.

In an embodiment, an end portion of the third conductive layer corresponding to the first portion of the power voltage supply line may include a tip protruding more than a side surface of the second conductive layer corresponding to the first portion.

In an embodiment, an end portion of the first conductive layer corresponding to the first portion of the power voltage supply line may include a tip protruding more than the side surface of the second conductive layer.

In an embodiment, a side surface of the third conductive layer corresponding to the second portion of the power voltage supply line may be located on the same inclined surface as a side surface of the second conductive layer corresponding to the second portion.

In an embodiment, a side surface of the first conductive layer corresponding to the second portion of the power voltage supply line may be located on the same inclined surface as the side surface of the second conductive layer.

In an embodiment, the partition wall may include an organic insulating material, and a side surface of the second portion of the power voltage supply line may directly contact the organic insulating material of the partition wall.

In an embodiment, in a plan view, an edge of the power voltage supply line may include an uneven structure having a concave portion and a convex portion that are alternately arranged.

In an embodiment, the display apparatus may further include a pad in the peripheral area, and that may include the same material as a material of the power voltage supply line.

In an embodiment, the pad may include: a first pad layer having a first width; and a second pad layer on the first pad layer, and having a second width greater than the first width.

In an embodiment, each of the first pad layer and the second pad layer may include: a first sub-layer; a second sub-layer on the first sub-layer; and a third sub-layer on the second sub-layer, and the second sub-layer may have an etch rate different from an etch rate of the first sub-layer and an etch rate of the third sub-layer.

In an embodiment, an end portion of the first sub-layer of the second pad layer or an end portion of the third sub-layer of the second pad layer may include a tip protruding more than a side surface of the second sub-layer of the second pad layer.

In an embodiment, the display apparatus may further include an insulating layer on the second pad layer, and that may include an opening overlapping with a part of a top surface of the second pad layer.

In an embodiment, the display apparatus may further include a third pad layer contacting the part of the top surface of the second pad layer through the opening of the insulating layer.

In an embodiment, the third pad layer may include a transparent conductive oxide, or may have a stacked structure of a plurality of metal layers having different etch rates from one another.

According to one or more embodiments of the present disclosure, a display apparatus includes: a plurality of transistors in a display area; a plurality of light-emitting diodes in the display area, and electrically connected to the plurality of transistors; an encapsulation layer on the plurality of light-emitting diodes; a first power voltage supply line in a peripheral area outside the display area; a second power voltage supply line in the peripheral area, and configured to supply a voltage different from a voltage of the first power voltage supply line; a partition wall in the peripheral area, and overlapping with a part of the first power voltage supply line and a part of the second power voltage supply line; and a pad in the peripheral area. Each of the first power voltage supply line and the second power voltage supply line has a multi-layered structure including: a first conductive layer; a second conductive layer on the first conductive layer; and a third conductive layer on the second conductive layer. The pad includes a pad layer including: a first sub-layer; a second sub-layer on the first sub-layer; and a third sub-layer on the second sub-layer. The first conductive layer and the first sub-layer includes the same material as each other, the second conductive layer and the second sub-layer includes the same material as each other, and the third conductive layer and the third sub-layer includes the same material as each other.

In an embodiment, an end portion of the third conductive layer corresponding to a first portion of the first power voltage supply line that does not overlap with the partition wall may include a tip protruding more than a side surface of the second conductive layer corresponding to the first portion.

In an embodiment, the first conductive layer and the third conductive layer may include the same metal as each other, and an end portion of the first conductive layer corresponding to the first portion of the first power voltage supply line may include a tip protruding more than the side surface of the second conductive layer.

In an embodiment, a side surface of the third conductive layer corresponding to a second portion of the first power voltage supply line overlapping with the partition wall may be located on the same inclined surface as a side surface of the second conductive layer corresponding to the second portion.

In an embodiment, the first conductive layer and the third conductive layer may include the same metal as each other, and a side surface of the first conductive layer corresponding to the second portion of the first power voltage supply line may be located on the same inclined surface as a side surface of the second conductive layer corresponding to the second portion.

In an embodiment, the partition wall may include an organic insulating material, and a side surface of a second portion of the first power voltage supply line, which may overlap with the partition wall, may directly contact the organic insulating material of the partition wall.

In an embodiment, in a plan view, each of an edge of the first power voltage supply line and an edge of the second power voltage supply line may have an uneven structure having a concave portion and a convex portion that are alternately arranged.

In an embodiment, the pad layer may include: a first pad layer having a first width; and a second pad layer on the first pad layer, and having a second width greater than the first width, and each of the first pad layer and the second pad layer may include the first sub-layer, the second sub-layer, and the third sub-layer.

In an embodiment, an end portion of the first sub-layer of the second pad layer or an end portion of the third sub-layer of the second pad layer may include a tip protruding more than a side surface of the second sub-layer of the second pad layer.

In an embodiment, the display apparatus may further include an insulating layer on the second pad layer, and that may include an opening overlapping with a part of a top surface of the second pad layer.

In an embodiment, the display apparatus may further include a third pad layer contacting the part of the top surface of the second pad layer through the opening of the insulating layer.

In an embodiment, the third pad layer may include a transparent conductive oxide or may have a stacked structure of a plurality of metal layers having different etch rates from each other.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a plan view schematically illustrating a display apparatus, according to an embodiment;
FIG. 2 is an equivalent circuit diagram illustrating a light-emitting diode and a sub-pixel circuit corresponding to a sub-pixel of a display apparatus, according to an embodiment;
FIG. 3 is a cross-sectional view taken along the line III-III' of the display apparatus of FIG. 1, according to an embodiment;
FIG. 4 is a plan view schematically illustrating a display apparatus, according to an embodiment;
FIG. 5 is an enlarged plan view illustrating the portion V of the display apparatus of FIG. 4, according to an embodiment;
FIG. 6 is a cross-sectional view taken along the line VI-VI' of FIG. 5;
FIG. 7 is a cross-sectional view taken along the line VII-VII' of FIG. 5;
FIG. 8 is a cross-sectional view taken along the line VIII-VIII' of FIG. 5;
FIG. 9 is a cross-sectional view taken along the line IX-IX' of FIG. 5;
FIG. 10 is a plan view illustrating a pad located in an inlet area of a display apparatus, according to an embodiment;
FIG. 11 is a cross-sectional view taken along the line XI-XI' of FIG. 10; and
FIGS. 12-14 are cross-sectional views illustrating a pad, according to one or more embodiments.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

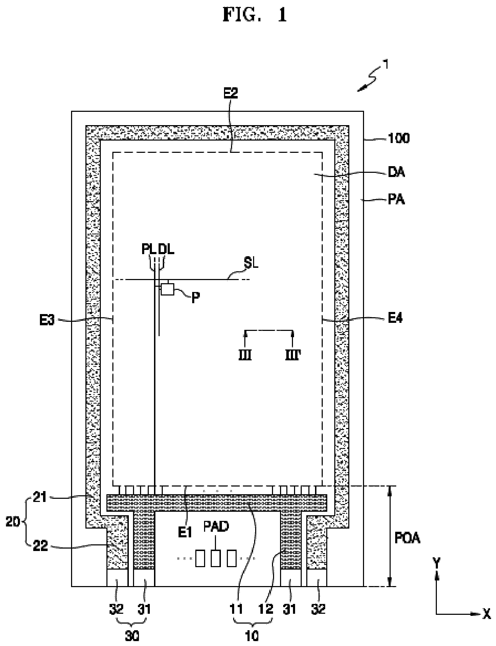

FIG. 1 is a plan view schematically illustrating a display apparatus, according to an embodiment.

Referring to FIG. 1, a display apparatus 1 may provide an image through a plurality of sub-pixels P located in a display area DA. Each sub-pixel P may emit, for example, red light, green light, or blue light. As another example, each sub-pixel P may emit red light, green light, blue light, or white light. Each sub-pixel P may emit red light, green light, or blue light through a light-emitting diode. Each light-emitting diode may be electrically connected to a sub-pixel circuit including a transistor and a storage capacitor. Each sub-pixel circuit may be electrically connected to a scan line SL extending in the x-direction, and a data line DL extending in the y-direction crossing the scan line SL.

A peripheral area PA is located outside the display area DA. The peripheral area PA may surround (e.g., around a periphery of) the display area DA. The peripheral area PA is a portion where the sub-pixels P are not located, and corresponds to a non-display area where an image is not provided.

A first power voltage supply line 10 and a second power voltage supply line 20 may be located in the peripheral area PA. The first power voltage supply line 10 may be located to correspond to a first side E1 of the display area DA, and the second power voltage supply line 20 may be located to correspond to second, third, and fourth sides E2, E3, and E4 of the display area DA. In FIG. 1, the first power voltage supply line 10 is located between the first side E1 of the display area DA and a terminal unit (e.g., a terminal or terminal circuit) 30, and the second power voltage supply line 20 partially surrounds (e.g., around a periphery of) the display area DA in a loop shape with one open side, for example, such as in a loop shape in which a portion corresponding to the first side E1 is open.

The first power voltage supply line 10 includes a first body portion 11 extending along the first side E1 of the display area DA. The first body portion 11 may extend in the x-direction along the first side E1 of the display area DA, and may have a length equal to or greater than that of the first side E1.

The first body portion 11 may be integrally formed with a first connecting portion 12 extending in the y-direction from the first body portion 11. The first connecting portion 12 may extend in the y-direction toward the terminal unit 30 in an inlet area POA. The inlet area POA is a portion of the peripheral area PA between the first side E1 of the display area DA adjacent to the terminal unit 30 and a side of the substrate 100, and may be a portion from the first side E1 of the display area DA to the terminal unit 30. The first connecting portion 12 may extend from the first body portion 11 toward an edge of the substrate 100, and may be connected to a first terminal 31 of the terminal unit 30.

The second power voltage supply line 20 includes a second body portion 21 extending along the second to fourth sides E2, E3, and E4 of the display area DA. The second body portion 21 may partially surround (e.g., around a periphery of) the display area DA along the second to fourth sides E2, E3, and E4, except for the first side E1 of the display area DA. The second side E2 is located opposite to the first side E1, and the third and fourth sides E3 and E4 connect the first side E1 and the second side E2 to each other and are located opposite to each other. The second body portion 21 may surround (e.g., around at least a portion of a periphery of) the display area DA, and may surround (e.g., around a periphery of) opposite sides of the first body portion 11.

The second body portion 21 may be integrally formed with a second connecting portion 22 extending in the y-direction from the second body portion 21. The second connecting portion 22 may extend in the y-direction toward the terminal unit 30 in the inlet area POA. The second connecting portion 22 may extend parallel to or substantially parallel to the first connecting portion 12 in the inlet area POA, and may be connected to a second terminal 32 of the terminal unit 30.

The terminal unit 30 may correspond to an end portion of the substrate 100, may be exposed without being covered by an insulating layer or the like, and may be connected to a controller through a flexible printed circuit board or the like.

A pad PAD may be located in the inlet area POA. The pads PAD may be spaced apart from each other in the inlet area POA. The pad PAD is an element to which an electronic device, for example, such as an integrated circuit (IC) chip or a printed circuit board including a data driver, is electrically connected. In some embodiments, an anisotropic conductive film may be located between the pad PAD and the electronic device.

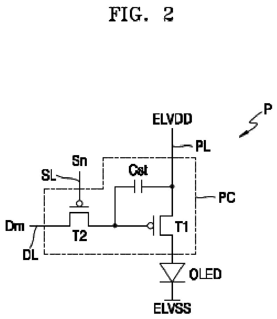

The first power voltage supply line 10 may provide a first power voltage ELVDD (e.g., see FIG. 2) to each sub-pixel P, and the second power voltage supply line 20 may provide a second power voltage ELVSS (e.g., see FIG. 2) to each sub-pixel P. For example, the first power voltage ELVDD of the first power voltage supply line 10 may be provided to a transistor corresponding to each sub-pixel P through a driving voltage line PL connected to the first power voltage supply line 10. The second power voltage ELVSS of the second power voltage supply line 20 may be provided to a second electrode (e.g., a cathode) of a light-emitting diode. The second body portion 21 of the second power voltage supply line 20 and the second electrode of the light-emitting diode may be connected to each other in the peripheral area PA to provide the second power voltage ELVSS.

According to an embodiment, the display apparatus 1 for displaying a moving image and/or a still image may be used as a display screen for a portable electronic device, such as a mobile phone, a smartphone, a tablet personal computer (PC), a laptop computer, a mobile communication terminal, an electronic organizer, an electronic book, a portable multimedia player (PMP), a navigation device, or an ultra-mobile PC (UMPC), as well as for any of various suitable products, such as a television, a monitor, an advertisement board, or an Internet of things (IoT) product. Also, the display apparatus 1 according to an embodiment may be used in a wearable device, such as a smart watch, a watch phone, a glasses-type display, or a head-mounted display (HMD). Also, the display apparatus 1 according to an embodiment may be used as a center information display (CID) located on an instrument panel, a center fascia, or a dashboard of a vehicle, a mirror display used in a vehicle, or a display located on the back of a front seat for entertainment for a back seat of a vehicle.

FIG. 2 is an equivalent circuit diagram illustrating a light-emitting diode and a sub-pixel circuit corresponding to a sub-pixel of a display apparatus, according to an embodiment. Although the light-emitting diode is illustrated as an organic light-emitting diode OLED in FIG. 2 for convenience of illustration, the present disclosure is not limited thereto. In another embodiment, the light-emitting diode may include any of various suitable kinds of light-emitting diodes, such as a diode including an inorganic material (e.g., a PN junction light-emitting diode), or a light-emitting diode including quantum dots.

Referring to FIG. 2, the light-emitting diode may be electrically connected to a transistor. For example, the organic light-emitting diode OLED may be electrically connected to a sub-pixel circuit PC, and the sub-pixel circuit PC may include a first transistor T1, a second transistor T2, and a storage capacitor Cst. A first electrode (e.g., an anode) of the organic light-emitting diode OLED may be electrically connected to the first transistor T1, and a second electrode (e.g., a cathode) of the organic light-emitting diode OLED may be electrically connected to the second power voltage supply line 20 to receive a voltage corresponding to the second power voltage ELVSS.

The second transistor T2 transmits a data signal Dm input through the data line DL according to a scan signal Sn input through the scan line SL to the first transistor T1.

The storage capacitor Cst is connected to the second transistor T2 and the driving voltage line PL, and stores a voltage corresponding to a difference between a voltage received from the second transistor T2 and the first power voltage ELVDD supplied to the driving voltage line PL.

The first transistor T1 may be connected to the driving voltage line PL and the storage capacitor Cst, and may control a driving current flowing through the organic light-emitting diode OLED from the driving voltage line PL in response to a value of the voltage stored in the storage capacitor Cst. The organic light-emitting diode OLED may emit light having a desired luminance (e.g., a certain or predetermined luminance) due to the driving current.

Although the sub-pixel circuit PC including two transistors and one storage capacitor is illustrated in FIG. 2, the present disclosure is not limited thereto. The sub-pixel circuit of the display apparatus according to another embodiment may include three or more transistors and two or more capacitors.

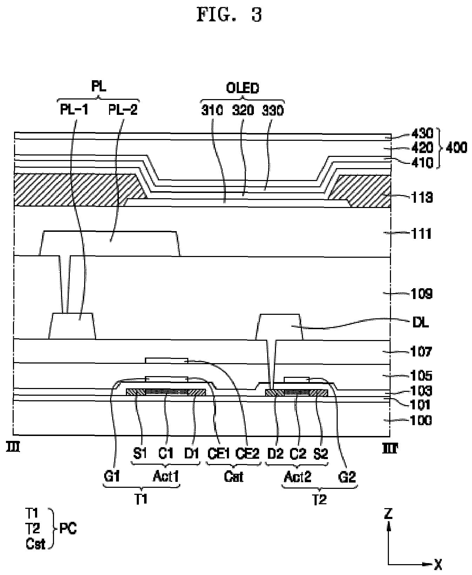

FIG. 3 is a cross-sectional view taken along the line III-III' of the display apparatus of FIG. 1, according to an embodiment.

Referring to FIG. 3, the sub-pixel circuit PC including the first and second transistors T1 and T2 and the storage capacitor Cst may be located on the substrate 100, and the organic light-emitting diode OLED may be located on the sub-pixel circuit PC.

The substrate 100 may include a glass material or a polymer resin. The polymer resin may include, for example, polyethersulfone (PES), polyacrylate (PAR), polyetherimide (PEI), polyethylene naphthalate (PEN), polyethylene terephthalate (PET), polyphenylene sulfide (PPS), polyarylate, polyimide (PI), polycarbonate (PC), or cellulose acetate propionate (CAP). The substrate 100 may have a single or multi-layered structure including one or more of the above materials, and the multi-layered structure may include a structure in which a polymer resin layer and a barrier layer including an inorganic insulating material are alternately stacked. The substrate 100 may be flexible, rollable, or bendable.

A buffer layer 101 may be located on the substrate 100 to prevent or substantially prevent penetration of impurities. The buffer layer 101 may include silicon oxide, silicon oxynitride, and/or silicon nitride.

The first transistor T1 includes a first semiconductor layer Act1 and a first gate electrode G1, and the second transistor T2 includes a second semiconductor layer Act2 and a second gate electrode G2. A first gate insulating layer 103 may be located between the first semiconductor layer Act1 and the first gate electrode G1, and between the second semiconductor layer Act2 and the second gate electrode G2. The first gate insulating layer 103 may include an inorganic insulating material, such as silicon oxide, silicon oxynitride, and/or silicon nitride, and may have a single or multi-layered structure.

Each of the first semiconductor layer Act1 and the second semiconductor layer Act2 may include a silicon semiconductor such as polysilicon, an oxide semiconductor, or an organic semiconductor. The first semiconductor layer Act1 may include a first channel region C1 overlapping with the first gate electrode G1, and a first source region S1 and a first drain region D1 on opposite sides of the first channel region C1. The second semiconductor layer Act2 may include a second channel region C2 overlapping with the second gate electrode G2, and a second source region S2 and a second drain region D2 on opposite sides of the second channel region C2.

The first gate electrode G1 and the second gate electrode G2 may be located on the first gate insulating layer 103 to overlap with the first channel region C1 and the second channel region C2, respectively. Each of the first gate electrode G1 and the second gate electrode G2 may include molybdenum (Mo), aluminum (Al), copper (Cu), or titanium (Ti), and may have a single or multi-layered structure.

As used in the present specification, a source region and a drain region of a transistor may correspond to a source electrode and a drain electrode of the transistor, respectively. For example, the first source region S1 and the first drain region D1 may be a first source electrode and a first drain electrode, respectively, and the second source region S2 and the second drain region D2 may be a second source electrode and a second drain electrode, respectively. Hereinafter, the terms "source region" and "drain region" may be used instead of the terms "source electrode" and "drain electrode" for convenience.

In an embodiment, the storage capacitor Cst may overlap with the first transistor T1. For example, the first gate electrode G1 may be a lower electrode CE1 of the storage capacitor Cst, and an upper electrode CE2 of the storage capacitor Cst may overlap with the lower electrode CE1. The upper electrode CE2 may include molybdenum (Mo), aluminum (Al), copper (Cu), or titanium (Ti), and may have a single or multi-layered structure.

A second gate insulating layer 105 may be located between the lower electrode CE1 and the upper electrode CE2. The second gate insulating layer 105 may include silicon oxide, silicon oxynitride, and/or silicon nitride, and may have a single or multi-layered structure including one or more of the above materials.

The first transistor T1, the second transistor T2, and the storage capacitor Cst may be covered by an interlayer insulating layer 107. The interlayer insulating layer 107 may include an inorganic insulating material, such as silicon oxide, silicon oxynitride, and/or silicon nitride. The data line DL is located on the interlayer insulating layer 107, and the data line DL is connected to the second semiconductor layer Act2 of the second transistor T2 through a contact hole passing through (e.g., penetrating) the first gate insulating layer 103, the second gate insulating layer 105 and the interlayer insulating layer 107. In FIG. 3, the data line DL is connected to the second drain region D2, and the data line DL may be the second drain electrode.

The driving voltage line PL is located on the interlayer insulating layer 107. The driving voltage line PL may include a lower driving voltage line PL-1 and an upper driving voltage line PL-2. In order to provide a high-quality image and/or implement a large display apparatus, it may be desirable to prevent or substantially prevent a voltage drop due to a resistance of the driving voltage line PL. As the driving voltage line PL according to an embodiment may include the lower driving voltage line PL-1 and the upper driving voltage line PL-2 that are electrically connected to each other with a first insulating layer 109 therebetween, an increase in the resistance of the driving voltage line PL may be prevented or substantially prevented, and a voltage drop due to the resistance of the driving voltage line PL may be prevented or substantially prevented. The upper driving voltage line PL-2 may be electrically connected to the lower driving voltage line PL-1 via a contact hole in the first insulating layer 109.

The lower driving voltage line PL-1 may include the same material as that of the data line DL. For example, the lower driving voltage line PL-1 may include molybdenum (Mo), aluminum (Al), copper (Cu), or titanium (Ti), and may have a single or multi-layered structure. In some embodiments, the lower driving voltage line PL-1 may have a multi-layered structure including Ti/Al/Ti.

The lower driving voltage line PL-1 and the upper driving voltage line PL-2 may be connected to each other through a contact hole defined in (e.g., penetrating) the first insulating layer 109 located between the lower driving voltage line PL-1 and the upper driving voltage line PL-2, and the driving voltage line PL may be covered by a second insulating layer 111 that is a planarization insulating layer. The upper driving voltage line PL-2 may include molybdenum (Mo), aluminum (Al), copper (Cu), or titanium (Ti), and may have a single or multi-layered structure. In some embodiments, the upper driving voltage line PL-2 may have a multi-layered structure including Ti/Al/Ti.

The first insulating layer 109 may include an inorganic insulating material and/or an organic insulating material. When the first insulating layer 109 includes the organic insulating material, the first insulating layer 109 may include an organic insulating material, such as an imide-based polymer, a general-purpose polymer (e.g., polymethyl methacrylate (PMMA) or polystyrene (PS)), a polymer derivative having a phenol-based group, an acrylic-based polymer, an aryl ether-based polymer, an amide-based polymer, a fluorine-based polymer, a p-xylene-based polymer, a vinyl alcohol-based polymer, or a suitable blend thereof.

The second insulating layer 111 may be located between the sub-pixel circuit PC and a first electrode 310 of the organic light-emitting diode OLED. The second insulating layer 111 may include an organic insulating material. For example, the second insulating layer 111 may include an imide-based polymer, a general-purpose polymer, such as polymethyl methacrylate (PMMA) or polystyrene (PS), a polymer derivative having a phenol-based group, an acrylic-based polymer, an aryl ether-based polymer, an amide-based polymer, a fluorine-based polymer, a p-xylene-based polymer, a vinyl alcohol-based polymer, or a suitable blend thereof.

The organic light-emitting diode OLED may have a stacked structure of the first electrode 310, an intermediate layer 320, and a second electrode 330. The first electrode 310 may be located on the second insulating layer 111. The first electrode 310 may include a metal and/or a conductive oxide. For example, the first electrode 310 may include a reflective film including silver (Ag), magnesium (Mg), aluminum (Al), platinum (Pt), palladium (Pd), gold (Au), nickel (Ni), neodymium (Nd), iridium (Ir), chromium (Cr), or a suitable compound thereof, and a film formed of ITO, IZO, ZnO, or In₂O₃ under and/or over the reflective film. In an embodiment, the first electrode 310 may have a structure in which an ITO layer, a silver (Ag) layer, and an ITO layer are sequentially stacked.

A bank layer 113 may cover an edge of the first electrode 310, and may include an opening overlapping with a part of the first electrode 310. The bank layer 215 may define a sub-pixel. For example, a width of the opening of the bank layer 113 through which a top surface of the first electrode 310 is exposed may correspond to a width of an emission area where light is emitted, or in other words, a width of the sub-pixel.

The bank layer 113 may include an insulating material. The bank layer 113 may include an organic insulating material, such as a general-purpose polymer (e.g., polymethyl methacrylate (PMMA) or polystyrene (PS)), a polymer derivative having a phenol-based group, an acrylic polymer, an imide-based polymer, an aryl ether-based polymer, an amide-based polymer, a fluorinated polymer, a p-xylene-based polymer, a vinyl alcohol-based polymer, or a suitable blend thereof.

The intermediate layer 320 includes an emission layer. The emission layer 320 may include a high molecular weight organic material or a low molecular weight organic material that emits light of a desired color (e.g., a certain or predetermined color). The intermediate layer 320 may include at least one functional layer. The at least one functional layer may include an organic material. For example, the intermediate layer 320 may include a first functional layer between the emission layer and the first electrode 310, and/or a second functional layer between the emission layer and the second electrode 330.

The first functional layer may have a single or multi-layered structure. For example, when the first functional layer is formed of a high molecular weight material, the first functional layer may include a hole transport layer (HTL) having a single-layer structure. When the first functional layer is formed of a low molecular weight material, the first functional layer may include a hole injection layer (HIL) and a hole transport layer (HTL).

The second functional layer may have a single or multi-layered structure. The second functional layer may include an electron transport layer (ETL) and/or an electron injection layer (EIL).

The second electrode 330 may be formed of a conductive material having a low work function. For example, the second electrode 330 may include a (semi-)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or a suitable alloy thereof. As another example, the second electrode 330 may further include a layer formed of ITO, IZO, ZnO, or In₂O₃ on the (semi-)transparent layer including one or more of the above materials. In an embodiment, the second electrode 330 may include silver (Ag) and magnesium (Mg). The second electrode 330 may be formed to entirely cover the display area DA (e.g., see FIG. 1). The second electrode 330 is a common layer, and may cover a plurality of first electrodes 310.

A thin-film encapsulation layer 400 may cover the organic light-emitting diode OLED. The thin-film encapsulation layer 400 may prevent or substantially prevent a light-emitting diode, such as the organic light-emitting diode OLED, from being damaged by external moisture and/or oxygen. The thin-film encapsulation layer 400 may include at least one organic encapsulation layer, and at least one inorganic encapsulation layer. In FIG. 3, the thin-film encapsulation layer 400 is illustrated as including a first inorganic encapsulation layer 410, an organic encapsulation layer 420 on the first inorganic encapsulation layer 410, and a second inorganic encapsulation layer 430 on the organic encapsulation layer 420.

The first inorganic encapsulation layer 410 may cover the second electrode 330, and may include silicon oxide, silicon nitride, and/or silicon oxynitride. In some embodiments, other layers, such as a capping layer, may be further located between the first inorganic encapsulation layer 410 and the second electrode 330 when necessary or desired. When the capping layer is not formed, the first inorganic encapsulation layer 410 may include at least two silicon oxynitride layers having different film qualities from one another.

The organic encapsulation layer 420 may include at least one material selected from the group consisting of an acrylic-based resin, a methacrylic-based resin, polyisoprene-based resin, a vinyl-based resin, an epoxy-based resin, a urethane-based resin, a cellulose-based resin, and a perylene-based resin. The second inorganic encapsulation layer 430 may cover the organic encapsulation layer 420, and may include silicon oxide, silicon nitride, and/or silicon oxynitride.

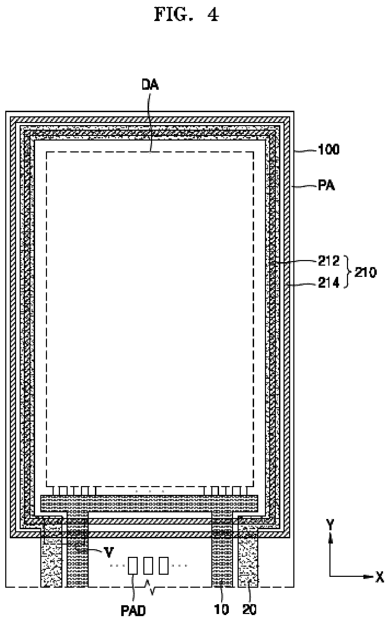

FIG. 4 is a plan view schematically illustrating a display apparatus, according to an embodiment.

FIG. 4 illustrates the first power voltage supply line 10 and the second power voltage supply line 20 located in the peripheral area PA, and a partition wall 210 and the pad PAD located over the first and second power voltage supply lines 10 and 20. The first power voltage supply line 10, the second power voltage supply line 20, and the pad PAD may be the same or substantially the same as those described above with reference to FIG. 1.

The organic encapsulation layer 420 described above with reference to FIG. 3 may be formed by applying a monomer, and then curing the monomer. The partition wall 210 may prevent or substantially prevent the monomer from overflowing and traveling to the pad PAD in a process of applying the monomer. The partition wall 210 may include a first partition wall 212 and a second partition wall 214 that are spaced apart from each other as shown in FIG. 4. Each of the first partition wall 212 and the second partition wall 214 may have a closed loop shape entirely surrounding (e.g., around a periphery of) the display area DA in a plan view as shown in FIG. 4.

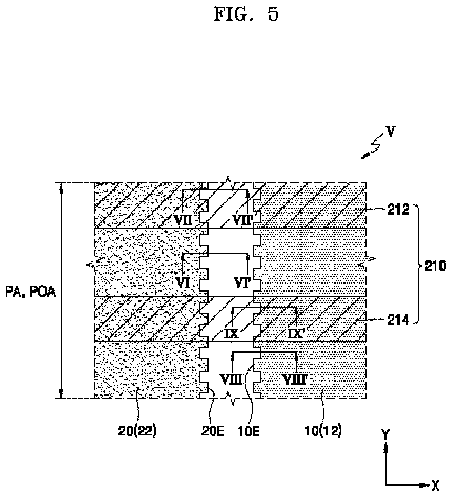

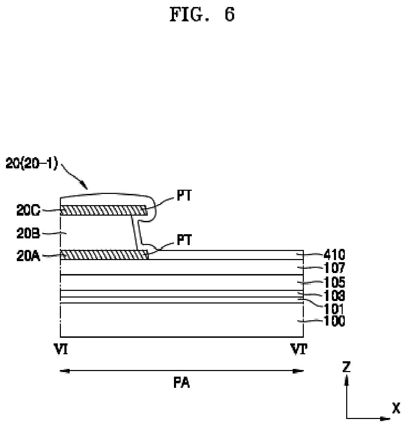

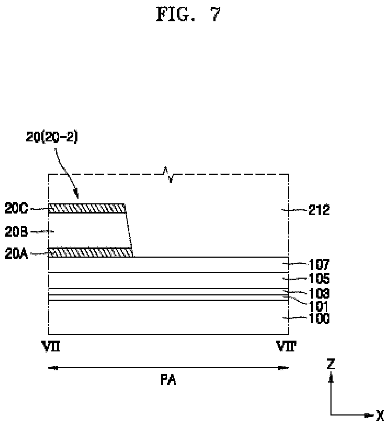

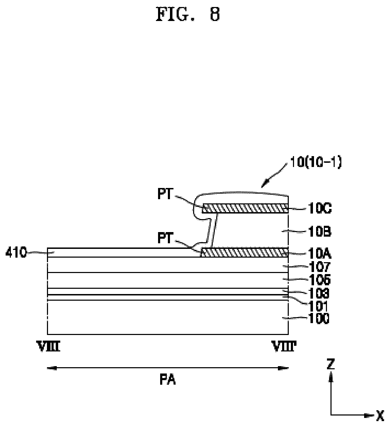

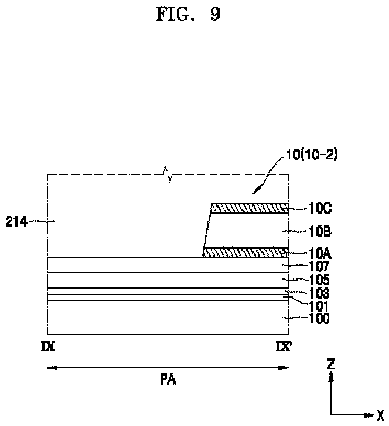

FIG. 5 is an enlarged plan view illustrating the portion V of the display apparatus of FIG. 4, according to an embodiment. FIG. 6 is a cross-sectional view taken along the line VI-VI' of FIG. 5. FIG. 7 is a cross-sectional view taken along the line VII-VII' of FIG. 5. FIG. 8 is a cross-sectional view taken along the line VIII-VIII' of FIG. 5. FIG. 9 is a cross-sectional view taken along the line IX-IX' of FIG. 5. FIG. 5 may be a plan view illustrating a part of the inlet area POA described above with reference to FIG. 1.

Referring to FIG. 5, in the peripheral area PA, for example, in the inlet area POA, a part of the first power voltage supply line 10 and a part of the second power voltage supply line 20 may cross the partition wall 210. For example, each of the first connecting portion 12 of the first power voltage supply line 10 and the second connecting portion 22 of the second power voltage supply line 20 may extend in the y-direction in the inlet area POA, and the partition wall 210 may cross each of the first connecting portion 12 of the first power voltage supply line 10 and the second connecting portion 22 of the second power voltage supply line 20. The first partition wall 212 may cross the first connecting portion 12 of the first power voltage supply line 10 and the second connecting portion 22 of the second power voltage supply line 20. The second partition wall 214 may cross the first connecting portion 12 of the first power voltage supply line 10 and the second connecting portion 22 of the second power voltage supply line 20.

Each of an edge 10E of the first power voltage supply line 10 and an edge 20E of the second power voltage supply line 20 may have an uneven structure in which a concave portion and a convex portion are alternately arranged in a plan view. Even when moisture penetrates from the peripheral area PA toward the display area DA (e.g., see FIG. 1) through the edge 10E of the first power voltage supply line 10 and/or the edge 20E of the second power voltage supply line 20, the traveling of the moisture may be delayed by the uneven structure of the edge 10E of the first power voltage supply line 10 and the edge 20E of the second power voltage supply line 20.

The first power voltage supply line 10 and/or the second power voltage supply line 20 may have a stacked structure of conductive layers. For example, as shown in FIGS. 6 through 9, the first power voltage supply line 10 and the second power voltage supply line 20 may have stacked structures including first conductive layers 10A and 20A, second conductive layers 10B and 20B on the first conductive layers 10A and 20A, and third conductive layers 10C and 20C on the second conductive layers 10B and 20B. The first conductive layer 10A, the second conductive layer 10B, and the third conductive layer 10C of the first power voltage supply line 10 may include the same materials as those of the first conductive layer 20A, the second conductive layer 20B, and the third conductive layer 20C of the second power voltage supply line 20.

Insulating layers, for example, such as inorganic insulating layers, may be located between the substrate 100 and the first power voltage supply line 10, and between the substrate 100 and the second power voltage supply line 20. In an embodiment, in a cross-sectional view as shown in FIGS. 6 to 9, the buffer layer 101, the first gate insulating layer 103, the second gate insulating layer 105, and the interlayer insulating layer 107 are located between the substrate 100 and the first power voltage supply line 10, and between the substrate 100 and the second power voltage supply line 20.

Each of the first conductive layers 10A and 20A, the second conductive layers 10B and 20B, and the third conductive layers 10C and 20C may include a conductive material, for example, such as a metal material. Each of the first conductive layers 10A and 20A, the second conductive layers 10B and 20B, and the third conductive layers 10C and 20C may include molybdenum (Mo), aluminum (Al), copper (Cu), or titanium (Ti), and may have a single or multi-layered structure. A metal included in the second conductive layers 10B and 20B may have an etch rate different from that of a metal included in the first conductive layers 10A and 20A and/or the third conductive layers 10C and 20C. In an embodiment, the second conductive layers 10B and 20B may include aluminum, and the first conductive layers 10A and 20A and the third conductive layers 10C and 20C may include titanium, but the present disclosure is not limited thereto.

A side shape (or a cross-sectional shape) of a portion of the first power voltage supply line 10 not overlapping with the partition wall 210 may be different from a side shape (or a cross-sectional shape) of a portion of the first power voltage supply line 10 overlapping with the partition wall 210. A side shape (or a cross-sectional shape) of a portion of the second power voltage supply line 20 not overlapping with the partition wall 210 may be different from a side shape (or a cross-sectional shape) of a portion of the second power voltage supply line 20 overlapping with the partition wall 210.

Referring to FIG. 6, a side surface of a portion 20-1 (hereinafter, referred to as a first portion) of the second power voltage supply line 20 not overlapping with the partition wall 210 may have a tip structure. In other words, a side surface of the first conductive layer 20A and a side surface of the third conductive layer 20C corresponding to the first portion 20-1 of the second power voltage supply line 20 are not located on the same plane as a side surface of the second conductive layer 20B.

As shown in FIG. 6, an end portion of the third conductive layer 20C corresponding to the first portion 20-1 of the second power voltage supply line 20 may include a tip PT protruding more laterally than the side surface of the second conductive layer 20B corresponding to the first portion 20-1 of the second power voltage supply line 20. In other words, the end portion of the third conductive layer 20C may include the tip PT further protruding in a lateral direction from a point where the side surface of the second conductive layer 20B and a bottom surface of the third conductive layer 20C meet each other. Likewise, an end portion of the first conductive layer 20A corresponding to the first portion 20-1 of the second power voltage supply line 20 may include a tip PT protruding more laterally than the side surface of the second conductive layer 20B corresponding to the first portion 20-1 of the second power voltage supply line 20. In other words, the end portion of the first conductive layer 20A may include the tip PT further protruding in a lateral direction from a point where the side surface of the second conductive layer 20B and a top surface of the first conductive layer 20A meet each other. The second conductive layer 20B having an etch rate different from that of the first conductive layer 20A and the third conductive layer 20C may be etched more when the second power voltage supply line 20 is etched in a process of manufacturing a display apparatus, and thus, each of the first conductive layer 20A and the third conductive layer 20C may include the tip PT.

The first inorganic encapsulation layer 410 may extend to the peripheral area PA, and may continuously cover the side surface of the first portion 20-1 of the second power voltage supply line 20 in the peripheral area PA. The first inorganic encapsulation layer 410 having relatively excellent step coverage may continuously cover the side surface of the first portion 20-1 of the second power voltage supply line 20 having the tip PT, but may not have a constant or substantially constant thickness (e.g., in the z-direction).

Referring to FIG. 7, a side surface of a portion 20-2 (hereinafter, referred to as a second portion) of the second power voltage supply line 20 overlapping with the partition wall 210, for example, such as the first partition wall 212, may have a gently inclined surface without including a tip. For example, a side surface of the first conductive layer 20A, a side surface of the second conductive layer 20B, and a side surface of the third conductive layer 20C may be located on the same or substantially the same plane (e.g., the inclined surface) as each other. The side surface of the second power voltage supply line 20 under the partition wall 210, for example, such as the first partition wall 212, may have a forward tapered inclined surface without including a tip. For example, a side surface of the first conductive layer 20A, a side surface of the second conductive layer 20B, and a side surface of the third conductive layer 20C may be located on the forward tapered inclined surface.

The second portion 20-2 of the second power voltage supply line 20 may overlap with the first partition wall 212. For example, as shown in FIG. 7, a top surface and a side surface of the second portion 20-2 of the second power voltage supply line 20 may directly contact the first partition wall 212. In some embodiments, the first partition wall 212 may include an organic insulating material, and the top surface and the side surface of the second portion 20-2 of the second power voltage supply line 20 may directly contact the organic insulating material of the first partition wall 212.

As described above with reference to FIGS. 6 and 7, because the first portion 20-1 of the second power voltage supply line 20 includes the tip PT, whereas the second portion 20-2 of the second power voltage supply line 20 may have a gentle side slope, a cavity (e.g., an unnecessary cavity) may not be formed between the partition wall 210, for example, such as the first partition wall 212, located on the second portion 20-2 of the second power voltage supply line 20 and the second portion 20-2 of the second power voltage supply line 20.

In a comparative example, when the partition wall 210 is formed on the second power voltage supply line 20 including the tip PT as shown in FIG. 6, it may be difficult for an organic insulating material corresponding to the partition wall 210 to fill a space under the tip PT. Accordingly, a cavity (e.g., an unnecessary cavity) may be formed between the second portion 20-2 of the second power voltage supply line 20 and the partition wall 210, for example, such as the first partition wall 212. However, because a side surface of the second portion 20-2 of the second power voltage supply line 20 has a gently inclined surface as shown in FIG. 7, the cavity may not be formed, and the partition wall 210 may be prevented or substantially prevented from being separated or detached from the second portion 20-2 of the second power voltage supply line 20 due to the cavity. Also, impurities may be prevented or substantially prevented from traveling through a cavity between the partition wall 210 and the second portion 20-2 of the second power voltage supply line 20, or from damaging a structure around the cavity. Also, because there may be no over-etching of the second conductive layer 20B corresponding to the second portion 20-2 of the second power voltage supply line 20, a decrease in the resistance of the second power voltage supply line 20 under the first partition wall 212 may be prevented or substantially prevented.

Although FIG. 7 illustrates a cross-sectional structure of a portion of the second power voltage supply line 20 under the first partition wall 212, the present disclosure is not limited thereto. A cross-sectional structure of a portion of the second power voltage supply line 20 under the second partition wall 214 may be the same or substantially the same as that shown in FIG. 7.

Referring to FIG. 8, a side surface of a portion 10-1 (hereinafter, referred to as a first portion) of the first power voltage supply line 10 not overlapping with the partition wall 210 may have a tip structure. For example, each of a side surface of the first conductive layer 10A and a side surface of the third conductive layer 10C corresponding to the first portion 10-1 of the first power voltage supply line 10 is not located on the same plane as a side surface of the second conductive layer 10B.

As shown in FIG. 8, an end portion of the third conductive layer 10C corresponding to the first portion 10-1 of the first power voltage supply line 10 may include a tip PT protruding more laterally than the side surface of the second conductive layer 10B corresponding to the first portion 10-1 of the first power voltage supply line 10. In other words, the end portion of the third conductive layer 10C may include the tip PT further protruding in a lateral direction from a point where the side surface of the second conductive layer 10B and a bottom surface of the third conductive layer 10C meet each other. Likewise, an end portion of the first conductive layer 10A corresponding to the first portion 10-1 of the first power voltage supply line 10 may include a tip PT protruding more laterally than the side surface of the second conductive layer 10B corresponding to the first portion 10-1 of the first power voltage supply line 10. In other words, the end portion of the first conductive layer 10A may include the tip PT further protruding in a lateral direction from a point where the side surface of the second conductive layer 10B and a top surface of the first conductive layer 10A meet each other. The second conductive layer 10B having an etch rate different from that of the first conductive layer 10A and/or the third conductive layer 10C may be etched more when the first power voltage supply line 10 is etched in a process of manufacturing the display apparatus, and thus, each of the first conductive layer 10A and the third conductive layer 10C may include the tip PT.

The first inorganic encapsulation layer 410 may extend to the peripheral area PA, and may continuously cover the side surface of the first portion 10-1 of the first power voltage supply line 10 in the peripheral area PA. The first inorganic encapsulation layer 410 having relatively excellent step coverage may continuously cover the side surface of the first portion 10-1 of the first power voltage supply line 10 having the tip PT, but may not have a constant or substantially constant thickness.

Referring to FIG. 9, a side surface of a portion 10-2 (hereinafter, referred to as a second portion) of the first power voltage supply line 10 overlapping with the partition wall 210, for example, such as the second partition wall 214, may have a gently inclined surface without including a tip. For example, a side surface of the first conductive layer 10A, a side surface of the second conductive layer 10B, and a side surface of the third conductive layer 10C may be located on the same or substantially the same plane (e.g., the inclined surface) as each other. The side surface of the first power voltage supply line 10 under the partition wall 210, for example, such as the second partition wall 214, may have a forward tapered inclined surface without including a tip. For example, the side surfaces of the first conductive layer 10A, the second conductive layer 10B, and the third conductive layer 10C may be located on the forward tapered inclined surface.

The second portion 10-2 of the first power voltage supply line 10 may overlap with the second partition wall 214. For example, as shown in FIG. 9, a top surface and a side surface of the second portion 10-2 of the first power voltage supply line 10 may directly contact the second partition wall 214. In some embodiments, the second partition wall 214 may include an organic insulating material, and the top surface and the side surface of the second portion 10-2 of the first power voltage supply line 10 may directly contact the organic insulating material of the second partition wall 214.

As described above with reference to FIGS. 8 and 9, because the first portion 10-1 of the first power voltage supply line 10 includes the tip PT, whereas the second portion 10-2 of the first power voltage supply line 10 may have a gentle side slope, a cavity (e.g., an unnecessary cavity) may not be formed between the partition wall 210, for example, such as the second partition wall 214, located on the second portion 10-2 of the first power voltage supply line 10 and the second portion 10-2 of the first power voltage supply line 10.

In a comparative example, when the partition wall 210 is formed on the first power voltage supply line 10 including the tip PT as shown in FIG. 8, it may be difficult for an organic insulating material corresponding to the partition wall 210 to fill a space under the tip PT. Accordingly, a cavity (e.g., an unnecessary cavity) may be formed between the second portion 10-2 of the first power voltage supply line 10 and the partition wall 210, for example, such as the second partition wall 214. However, because the side surface of the second portion 10-2 of the first power voltage supply line 10 has a gently inclined surface as shown in FIG. 9, the cavity may not be formed, and the partition wall 210 may be prevented or substantially prevented from being separated or detached from the second portion 10-2 of the first power voltage supply line 10 due to the cavity. Also, impurities may be prevented or substantially prevented from traveling through a cavity between the partition wall 210 and the second portion 10-2 of the first power voltage supply line 10, or from damaging a structure around the cavity. Also, because there may be no over-etching of the second conductive layer 10B corresponding to the second portion 10-2 of the first power voltage supply line 10, a decrease in the resistance of the first power voltage supply line 10 under the second partition wall 214 may be prevented or substantially prevented.

Although FIG. 9 illustrates a cross-sectional structure of a portion of the first power voltage supply line 10 under the second partition wall 214, the present disclosure is not limited thereto. A cross-sectional structure of a portion of the first power voltage supply line 10 under the first partition wall 212 may be the same or substantially the same as that shown in FIG. 9.

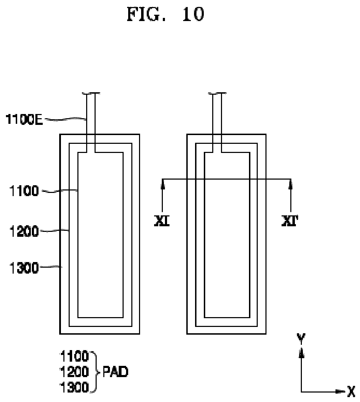

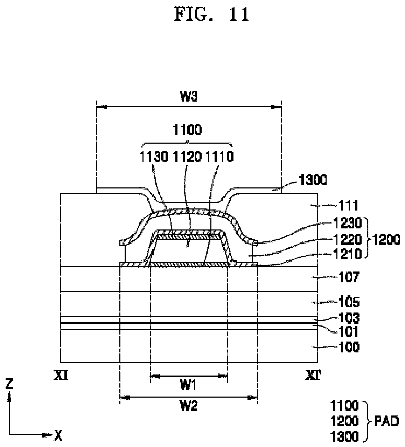

FIG. 10 is a plan view illustrating a pad located in an inlet area of a display apparatus, according to an embodiment. FIG. 11 is a cross-sectional view taken along the line XI-XI' of FIG. 10.

Referring to FIG. 10, the pad PAD may have a stacked structure of a plurality of pad layers. As shown in FIG. 10, the pad PAD may include a first pad layer 1100, a second pad layer 1200 on the first pad layer 1100, and a third pad layer 1300 on the second pad layer 1200.

In a plan view, while the second pad layer 1200 and the third pad layer 1300 have isolated shapes, a part 1100E (hereinafter, referred to as an extending portion) of the first pad layer 1100 may extend toward the display area DA (e.g., see FIG. 1), and may be electrically connected to a signal line (e.g., a data line) located in the display area DA.

As shown in FIG. 11, a plurality of insulating layers, for example, such as inorganic insulating layers, may be located between the substrate 100 and the pad PAD. In an embodiment, in a cross-sectional view as illustrated in FIG. 11, the buffer layer 101, the first gate insulating layer 103, the second gate insulating layer 105, and the interlayer insulating layer 107 are located between the substrate 100 and the pad PAD.

A pad layer of the pad PAD may include the same material as that of the first power voltage supply line 10 (e.g., see FIG. 8) and/or the second power voltage supply line 20 (e.g., see FIG. 6). The first pad layer 1100 and/or the second pad layer 1200 may include the same material as that of the first power voltage supply line 10 and/or the second power voltage supply line 20, and may have the same stacked structure as that of the first power voltage supply line 10 and/or the second power voltage supply line 20. For example, the first pad layer 1100 may have a stacked structure of a first sub-layer 1110, a second sub-layer 1120 on the first sub-layer 1110, and a third sub-layer 1130 on the second sub-layer 1120. The second pad layer 1200 may have a stacked structure of a first sub-layer 1210, a second sub-layer 1220 on the first sub-layer 1210, and a third sub-layer 1230 on the second sub-layer 1220.

Each of the first sub-layers 1110 and 1210, the second sub-layers 1120 and 1220, and the third sub-layers 1130 and 1230 may include a conductive material, for example, such as a metal material. Each of the first sub-layers 1110 and 1210, the second sub-layers 1120 and 1220, and the third sub-layers 1130 and 1230 may include molybdenum (Mo), aluminum (Al), copper (Cu), or titanium (Ti), and may have a single or multi-layered structure. A metal included in the second sub-layers 1120 and 1220 may have an etch rate different from that of a metal included in the first sub-layers 1110 and 1210 and/or the third sub-layers 1130 and 1230.

The first sub-layers 1110 and 1210, the second sub-layers 1120 and 1220, and the third sub-layers 1130 and 1230 may respectively include the same materials as those of the first conductive layers 10A and 20A (e.g., see FIGS. 6 and 8), the second conductive layers 10B and 20B (e.g., see FIGS. 6 and 8), and the third conductive layers 10C and 20C (e.g., see FIGS. 6 and 8) of the first power voltage supply line 10 and the second power voltage supply line 20. In an embodiment, the second sub-layers 1120 and 1220 may include aluminum, and the first sub-layers 1110 and 1210 and the third sub-layers 1130 and 1230 may include titanium, but the present disclosure is not limited thereto.

The first pad layer 1100 may have a side surface having a relatively gentle slope in a cross-sectional view. For example, a side surface of the first sub-layer 1110, a side surface of the second sub-layer 1120, and a side surface of the third sub-layer 1130 may be located on the same or substantially the same plane, and may include a forward tapered inclined surface.

Each of the end portions of the first sub-layer 1210 and the third sub-layer 1230 of the second pad layer 1200 may include a tip protruding more laterally than a side surface of the second sub-layer 1220. A width W2 of the second pad layer 1200 may be greater than a width W1 of the first pad layer 1100. The second pad layer 1200 may cover a side surface of the first pad layer 1100. For example, each of opposite side surfaces of the first pad layer 1100 in a width direction (e.g., the x-direction) may be covered by the second pad layer 1200.

The second insulating layer 111 that is an organic insulating layer on the second pad layer 1200 may include an opening through which a part of a top surface of the second pad layer 1200 is exposed, and may cover opposite side surfaces of the second pad layer 1200 in the width direction. Because the second insulating layer 111 that is an organic insulating layer having a thickness greater than that of an inorganic insulating material covers opposite side surfaces of the second pad layer 1200, the influence of a tip structure of the second pad layer 1200 on a structure (e.g., a shape) of a surrounding layer, for example, such as the third pad layer 1300, in a process of forming the third pad layer 1300 may be minimized or reduced.

A width W3 of the third pad layer 1300 may be greater than the width W2 of the second pad layer 1200. The third pad layer 1300 may directly contact a part of a top surface of the second pad layer 1200 exposed through an opening of the second insulating layer 111, and a part of a top surface of the second insulating layer 111. The third pad layer 1300 may be a single layer including a transparent conductive oxide, such as ITO. An anisotropic conductive film may be further located on the third pad layer 1300, and an electronic device, such as an IC chip, may be located on the anisotropic conductive film as described above with reference to FIG. 1. As another example, an electronic device, such as a flexible printed circuit board (FPCB), may be located on the third pad layer 1300.

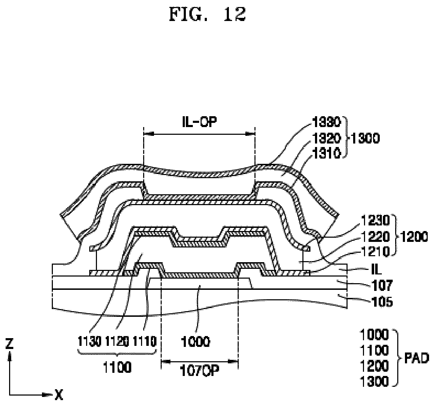

FIGS. 12 through 14 are cross-sectional views illustrating a pad, according to one or more embodiments.

Referring to FIG. 12, the pad PAD may include the first pad layer 1100, the second pad layer 1200 on the first pad layer 1100, the third pad layer 1300 on the second pad layer 1200, and a lower pad layer 1000 under the first pad layer 1100.

Each of the first pad layer 1100, the second pad layer 1200, and the third pad layer 1300 may have a stacked structure of a plurality of metal layers having different etch rates from one another. For example, the first pad layer 1100, the second pad layer 1200, and the third pad layer 1300 may respectively include first sub-layers 1110, 1210, and 1310, second sub-layers 1120, 1220, and 1320, and third sub-layers 1130, 1230, and 1330. A metal of the first sub-layers 1110, 1210, and 1310 and/or the third sub-layers 1130, 1230, and 1330 may have an etch rate different from that of a metal of the second sub-layers 1120, 1220, and 1320. For example, the first sub-layers 1110, 1210, and 1310 and/or the third sub-layers 1130, 1230, and 1330 may include titanium, and the second sub-layers 1120, 1220, and 1320 may include aluminum.

The lower pad layer 1000 may include the same material as that of one of a gate electrode of a transistor or an electrode of a storage capacitor described above with reference to FIG. 3. The lower pad layer 1000 may include molybdenum (Mo), aluminum (Al), copper (Cu), or titanium (Ti), and may have a single or multi-layered structure.

In an embodiment, the lower pad layer 1000 may be located on the second gate insulating layer 105. An edge of the lower pad layer 1000 may be covered by an inorganic insulating layer. For example, an edge of the lower pad layer 1000 may be covered by the interlayer insulating layer 107, and the interlayer insulating layer 107 may include an opening 107OP through which a part of a top surface of the lower pad layer 1000 is exposed.

The first pad layer 1100 may be electrically connected to the lower pad layer 1000 through the opening 107OP of the interlayer insulating layer 107. An insulating layer may not be located between the first pad layer 1100 and the second pad layer 1200. For example, the second pad layer 1200 may overlap with and contact a top surface and a side surface of the first pad layer 1100.

An insulating layer may be located on the second pad layer 1200, and the insulating layer may cover a side surface of the second pad layer 1200. For example, as shown in FIG. 12, an inorganic insulating layer IL may cover a side surface of the second pad layer 1200. The inorganic insulating layer IL may include a plurality of sub-inorganic insulating layers, and the plurality of sub-inorganic insulating layers may be a part of a thin-film encapsulation layer (e.g., a first inorganic encapsulation layer and/or a second inorganic encapsulation layer) and/or inorganic insulating layer(s) of a touch layer.

The third pad layer 1300 may be located on the inorganic insulating layer IL. The third pad layer 1300 may be electrically connected to the second pad layer 1200 through an opening IL-OP of the inorganic insulating layer IL. The third pad layer 1300 may directly contact a part of a top surface of the second pad layer 1200 through the opening IL-OP of the inorganic insulating layer IL.

A side surface of the third pad layer 1300 may not include a tip, unlike that of the second pad layer 1200. For example, a side surface of the first sub-layer 1310, a side surface of the second sub-layer 1320, and a side surface of the third sub-layer 1330 corresponding to the side surface of the third pad layer 1300 may be located on the same or substantially the same plane. In another embodiment, a side surface of the first sub-layer 1310 and/or a side surface of the third sub-layer 1330 of the third pad layer 1300 may protrude more than a side surface of the second sub-layer 1320.

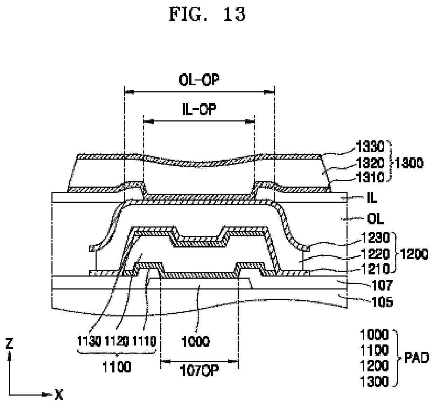

Referring to FIG. 13, the pad PAD may include the first pad layer 1100, the second pad layer 1200 on the first pad layer 1100, the third pad layer 1300 on the second pad layer 1200, and the lower pad layer 1000 under the first pad layer 1100 as described above with reference to FIG. 12.

A stacked structure of an organic insulating layer OL and the inorganic insulating layer IL may be located on the second pad layer 1200, and the organic insulating layer OL and the inorganic insulating layer IL may respectively include openings OL-OP and IL-OP, each overlapping with a part of the second pad layer 1200.

In an embodiment, the organic insulating layer OL may be the second insulating layer 111 described above with reference to FIG. 11, and the inorganic insulating layer IL may be a part of a thin-film encapsulation layer (e.g., a first inorganic encapsulation layer and/or a second inorganic encapsulation layer) and/or inorganic insulating layer(s) of a touch layer. The third pad layer 1300 may directly contact a top surface of the second pad layer 1200 through the opening IL-OP of the inorganic insulating layer IL and the opening OL-OP of the organic insulating layer OL.

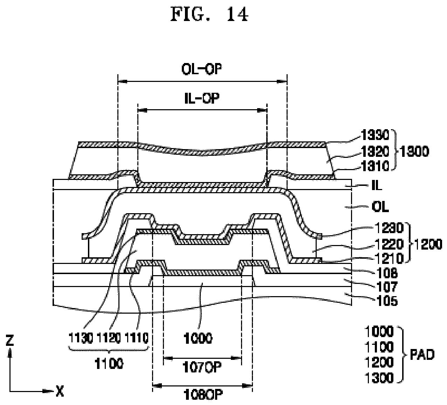

Referring to FIG. 14, the pad PAD may include the first pad layer 1100, the second pad layer 1200 on the first pad layer 1100, the third pad layer 1300 on the second pad layer 1200, and the lower pad layer 1000 under the first pad layer 1100. The stacked structure of the organic insulating layer OL and the inorganic insulating layer IL as described above with reference to FIG. 13 may be located between the second pad layer 1200 and the third pad layer 1300 of FIG. 14. In some embodiments, a width of the opening IL-OP of the inorganic insulating layer IL may be less than a width of the opening OL-OP of the organic insulating layer OL.

An insulating layer may be located between the first pad layer 1100 and the second pad layer 1200 of the pad PAD. For example, a side surface of the first pad layer 1100 may overlap with and be covered by an additional inorganic insulating layer 108. The additional inorganic insulating layer 108 may be located on the interlayer insulating layer 107, and may include an inorganic insulating material, such as silicon oxide, silicon oxynitride, and/or silicon nitride. The additional inorganic insulating layer 108 may include an opening 108OP overlapping with a part of the first pad layer 1100. A width of the opening 108OP of the additional inorganic insulating layer 108 may be greater than a width of the opening 107OP of the interlayer insulating layer 107. The second pad layer 1200 may directly contact a top surface of the first pad layer 1100 through the opening 108OP of the additional inorganic insulating layer 108.

According to one or more embodiments of the present disclosure, a display apparatus may be provided, in which defects caused by a shape of a power voltage supply line and/or a pad are minimized or reduced, and thus, damage caused by external impurities such as moisture during or after manufacture may be minimized or reduced. However, the aspects and features of the present disclosure are not limited thereto.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display apparatus (1) comprising:
a plurality of transistors (T1, T2) in a display area (DA);
a plurality of light-emitting diodes (OLED) in the display area (DA), and electrically connected to the plurality of transistors (T1, T2);
a power voltage supply line (10, 20) in a peripheral area (PA) outside the display area (DA);
a partition wall (210) in the peripheral area (PA), and overlapping with a part (1100E) of the power voltage supply line (10, 20); and
an encapsulation layer (320) on the plurality of light-emitting diodes (OLED),
wherein the power voltage supply line (10, 20) has a multi-layered structure comprising:
a first conductive layer (10A, 20A);
a second conductive layer (10B, 20B) on the first conductive layer (10A, 20A); and
a third conductive layer (10C, 20C) on the second conductive layer (10B, 20B), and
wherein a side shape of a first portion (10-1, 20-1) of the power voltage supply line (10, 20) that does not overlap with the partition wall (210) is different from a side shape of a second portion (10-2, 20-2) of the power voltage supply line (10, 20) overlapping with the partition wall (210).

2. The display apparatus (1) of claim 1,
wherein an end portion of the third conductive layer (10C, 20C) corresponding to the first portion (10-1, 20-1) of the power voltage supply line (10, 20) comprises a tip (PT) protruding more than a side surface of the second conductive layer (10B, 20B) corresponding to the first portion (10-1, 20-1); and/or
wherein an end portion of the first conductive layer (10A, 20A) corresponding to the first portion (10-1, 20-1) of the power voltage supply line (10, 20) comprises a tip (PT) protruding more than the side surface of the second conductive layer (10B, 20B).

3. The display apparatus (1) of claim 1,
wherein a side surface of the third conductive layer (10C, 20C) corresponding to the second portion (10-2, 20-2) of the power voltage supply line (10, 20) is located on a same inclined surface as a side surface of the second conductive layer (10B, 20B); and/or
wherein a side surface of the first conductive layer (10A, 20A) corresponding to the second portion (10-2, 20-2) of the power voltage supply line (10, 20) is located on a same inclined surface as the side surface of the second conductive layer (10B, 20B).

4. The display apparatus (1) of any one of the preceding claims, wherein the partition wall (210) comprises an organic insulating material, and a side surface of the second portion (10-2, 20-2) of the power voltage supply line (10, 20) directly contacts the organic insulating material of the partition wall (210).

5. The display apparatus (1) of any one of the preceding claims, wherein, in a plan view, an edge (10E, 20E) of the power voltage supply line (10, 20) comprises an uneven structure having a concave portion and a convex portion that are alternately arranged.

6. The display apparatus (1) of any one of the preceding claims, further comprising a pad (PAD) in the peripheral area (PA), and comprising the same material as a material of the power voltage supply line (10, 20).

7. The display apparatus (1) of claim 6, wherein the pad (PAD) comprises:
a first pad layer (1100) having a first width (W1); and
a second pad layer (1200) on the first pad layer (1100), and having a second width (W2) greater than the first width (W1).

8. The display apparatus (1) of claim 7, wherein each of the first pad layer (1100) and the second pad layer (1200) comprises:
a first sub-layer (1110, 1210, 1310);
a second sub-layer (1120, 1220, 1320) on the first sub-layer (1110, 1210, 1310); and
a third sub-layer (1130, 1230, 1330) on the second sub-layer (1120, 1220, 1320), and
wherein the second sub-layer (1120, 1220, 1320) has an etch rate different from an etch rate of the first sub-layer (1110, 1210, 1310) and an etch rate of the third sub-layer (1130, 1230, 1330).

9. A display apparatus (1) comprising:
a plurality of transistors (T1, T2) in a display area (DA);
a plurality of light-emitting diodes (OLED) in the display area (DA), and electrically connected to the plurality of transistors;
an encapsulation layer (320) on the plurality of light-emitting diodes (OLED);
a first power voltage supply line (10) in a peripheral area (PA) outside the display area (DA);
a second power voltage supply line (20) in the peripheral area (PA), and configured to supply a voltage different from a voltage of the first power voltage supply line (10);
a partition wall (210) in the peripheral area (PA), and overlapping with a part (1100E) of the first power voltage supply line (10) and a part (1100E) of the second power voltage supply line (20); and
a pad (PAD) in the peripheral area (PA),
wherein each of the first power voltage supply line (10) and the second power voltage supply line (20) has a multi-layered structure comprising:
a first conductive layer (10A, 20A);
a second conductive layer (10B, 20B) on the first conductive layer (10A, 20A); and
a third conductive layer (10C, 20C) on the second conductive layer (10B, 20B),
wherein the pad (PAD) comprises a pad layer (320) comprising:
a first sub-layer (1110, 1210, 1310);
a second sub-layer (1120, 1220, 1320) on the first sub-layer (1110, 1210, 1310); and
a third sub-layer (1130, 1230, 1330) on the second sub-layer (1120, 1220, 1320), and
wherein the first conductive layer (10A, 20A) and the first sub-layer (1110, 1210, 1310) comprise the same material as each other, the second conductive layer (10B, 20B) and the second sub-layer (1120, 1220, 1320) comprise the same material as each other, and the third conductive layer (10C, 20C) and the third sub-layer (1130, 1230, 1330) comprise the same material as each other.

10. The display apparatus (1) of claim 9, wherein an end portion of the third conductive layer (10C, 20C) corresponding to a first portion (10-1, 20-1) of the first power voltage supply line (10) that does not overlap with the partition wall (210) comprises a tip (PT) protruding more than a side surface of the second conductive layer (10B, 20B) corresponding to the first portion (10-1, 20-1).

11. The display apparatus (1) of claim 9 or 10, wherein the first conductive layer (10A, 20A) and the third conductive layer (10C, 20C) comprise the same metal as each other; and
wherein an end portion of the first conductive layer (10A, 20A) corresponding to the first portion (10-1, 20-1) of the first power voltage supply line (10) comprises a tip (PT) protruding more than the side surface of the second conductive layer (10B, 20B), and/or an end portion of the first conductive layer (10A, 20A) corresponding to the second portion (10-2, 20-2) of the first power voltage supply line (10) is located on the same inclined surface as the side surface of the second conductive layer (10B, 20B).

12. The display apparatus (1) of any one of claims 9 to 11, wherein a side surface of the third conductive layer (10C, 20C) corresponding to a second portion (10-2, 20-2) of the first power voltage supply line (10) overlapping with the partition wall (210) is located on a same inclined surface as the side surface of the second conductive layer (10B, 20B).

13. The display apparatus (1) of any one of claims 9 to 12, wherein the partition wall (210) comprises an organic insulating material, and a side surface of a second portion (10-2, 20-2) of the first power voltage supply line (10) directly contacts the organic insulating material of the partition wall (210).

14. The display apparatus (1) of any one of claims 9 to 13, wherein, in a plan view, each of an edge (10E, 20E) of the first power voltage supply line (10) and an edge (10E, 20E) of the second power voltage supply line (20) has an uneven structure having a concave portion and a convex portion that are alternately arranged.

15. The display apparatus (1) of any one of claims 9 to 14, wherein the pad layer (320) comprises:
a first pad layer (1100) having a first width (W1); and
a second pad layer (1200) on the first pad layer (1100), and having a second width (W2) greater than the first width (W1), and
wherein each of the first pad layer (1100) and the second pad layer (1200) comprises the first sub-layer (1110, 1210, 1310), the second sub-layer (1120, 1220, 1320), and the third sub-layer (1130, 1230, 1330).

16. The display apparatus (1) of claim 8 or 15, wherein an end portion of the first sub-layer (1110, 1210, 1310) of the second pad layer (1200) or an end portion of the third sub-layer (1130, 1230, 1330) of the second pad layer (1200) comprises a tip (PT) protruding more than a side surface of the second sub-layer (1120, 1220, 1320) of the second pad layer (1200).

17. The display apparatus (1) of claim 16, further comprising an insulating layer (320) on the second pad layer (1200), and comprising an opening (107OP, 108OP) overlapping with a part of a top surface of the second pad layer (1200).

18. The display apparatus (1) of claim 17, further comprising a third pad layer (1300) contacting the part of the top surface of the second pad layer (1200) through the opening (107OP, 108OP) of the insulating layer (320).

19. The display apparatus (1) of claim 18, wherein the third pad layer (1300) comprises a transparent conductive oxide, or has a stacked structure of a plurality of metal layers (320) having different etch rates from each other.
